# EUROPEAN PATENT SPECIFICATION

(11) **EP 0 465 399 B1**
(45) Date of publication and mention of the grant of the patent: **05.04.1995**
(21) Application number: 91630033.8
(22) Date of filing: 23.05.1991
(51) Int. Cl.: B29D 9/00, B29C 45/14, B29C 65/64

(54) **A process to manufacture conductive composite articles**
Verfahren zur Herstellung leitender mehrschichtiger Gegenstände
Procédé pour fabriquer des articles conducteurs stratifiés

(30) Priority: 29.05.1990 US 529408
(43) Date of publication of application: 08.01.1992
(73) Proprietor: UNITED TECHNOLOGIES CORPORATION, Hartford, CT 06101 (US)
(72) Inventor: Donecker, Peter Gregory, Durham, Connecticut 06422 (US); Diaz, Nestor Joseph, Seymour, Connecticut 06483 (US); Sauer, Jeffrey George, Asbury, New Jersey 08802 (US)
(74) Representative: Schmitz, Jean-Marie

(56) References cited:
- GB-A- 2 191 729
- US-A- 4 078 037
- US-A- 4 435 349
- US-A- 4 473 208

## Description

### Technical Field

This invention is directed to the manufacture of conductive composite articles using a resin transfer molding process.

### Background Art

Aircraft components must be conductive for reasons relating to lightning protection and EMI. These components have traditionally been manufactured with metals such as steel, aluminum, and titanium. Although metals are excellent conductors, they have high densities which make them less suitable to manufacture light weight vehicles.

Consequently, alternative material to construct aircraft parts, such as composites have been developed. Composite articles can presently be manufactured by such known processes as preimpregnation. In this process the fabric is impregnated with resin and catalyst which requires appropriate storing facilities with controlled temperatures, to prevent untimely curing. In addition, the resin/catalyst impregnated material has a shelf life limitation.

Resin transfer molding (RTM) is another method used to manufacture composite articles. This method is described in U.S. Patent No. 4,762,740 which is incorporated herein by reference. In RTM the resin and hardener, i.e. catalyst or cross-linking agent, are mixed just prior to injection into a mold containing a fiber preform. This method eliminates the shelf-life and storage problems of prepregging since the resin and catalyst are not mixed until injection.

Although prepreg and RTM processes will yield lighter weight articles than metals, the thermosetting and thermoplastic resin systems and the fabric material used in these methods are either nonconductive or not conductive enough for lightening strike and EMI protection. As a result, there is a need for a process to manufacture lightweight conductive articles. Conductive attributes can be added to composite articles by incorporating a metallic mesh in the article.

The previous methods to attach a dry metallic mesh to a dry (nonimpregnated) preform all have significant limitations. Spray adhesives reduce laminate strength, produce unacceptable cosmetic surfaces, and interfere with resin flow during injection. Preimpregnating the metallic mesh is not practical since the prepregged mesh is difficult to handle, and it has a limited shelf life and out time. Lastly, secondary bonding the dry metallic mesh to the cured part or mechanically attaching the mesh to the preform prior to curing are not structurally sound alternatives.

The need exists for a method to manufacture flat as well as complex configuration articles, to adhere a metal wire mesh to a fabric preform, and to eliminate the storage and shelf-life limitations of impregnated material.

### Disclosure of Invention

The present invention discloses a method to manufacture conductive, composite articles which are suited for the use in aircraft where conductivity is needed for lightening strike and EMI protection, and where a lower fuel consumption and higher performance for the aircraft are objectives. In addition, the disclosed method is especially suited for industries concerned with high production rates and low capital equipment investment.

The proposed process discloses a method to manufacture a conductive composite article starting with a fiber preform, a metallic mesh, adhesive resin film, and injection resin. A dry, and stabilized fiber preform is set on a resin transfer molding tool matched first half. Adhesive resin strips suited to the shape of the article being manufactured are cut with conventional cutting techniques from an adhesive resin film sheet. The film sheet has support backings on each side which protect the resin from contamination and provide stability and manageability. The support backing is removed from one surface of the resin strips and the exposed tacky resin is adhered to the fiber preform in a predetermined location. This process is repeated until the fiber preform surface has sufficient adhesive strips to retain the wire mesh preform. The remaining support backing is removed from the resin strips which have been adhered to the fiber preform. The precut and patterned metal wire mesh is placed onto the fiber preform and adhesive resin, and the metal mesh is secured to the fiber preform.

Adhesive resin strips can also be used to secure any metal wire mesh overlap to ensure a continuous metal mesh surface over the preform. If a second metal mesh is needed, for additional electrical protection, adhesive resin strips are used to secure the two interfacing metal meshes to each other.

The resin transfer molding tool is assembled by closing the matched second half of the tool on the fiber preform and metal mesh. A resin and cross-linking agent are mixed and injected into the tool and the assembly is cured according to the resin specifications, i.e. curing may occur within 0.5 hrs. and up to 8 hrs., and at temperatures ranging from 250°F to 400°F.

Although this process is applicable to the manufacture of flat objects it is especially useful for manufacturing articles with complex configurations, since the adhesive resin film provides the means to secure a metal mesh to the required curvature configurations without interfering with the subsequent injection of a matrix resin and without reducing the laminate strength.

The dry fiber preform is usually made of graphite fibers, fiberglass fibers, aramid fibers, or a combination thereof. If the fabric is made of graphite fibers, a fiberglass ply is incorporated in the fabric which acts as an electrical insulator. If a flat article is being manufactured, the preform fabric can be sewn or stapled to the desired pattern. Since the fiber preform is not impregnated with a resin matrix the problems of a limited shelf-life and storage at specific temperatures are eliminated.

Thus, an aspect of the invention is directed to the method of conforming and securing a wire mesh, in its desired shape, to a dry preform, or to a metal mesh. A tacky adhesive resin is used as the means to physically bond, by adhesion, the wire mesh and dry fiber preform or two metal meshes. During the cure cycle the resin film is chemically incorporated with the injected resin and cross-linking agent and it becomes part of the cured resin matrix.

It is necessary to incorporate a metal wire mesh, screen or fabric in the structure in order to give the article conductive properties. Typically, a metal wire mesh can be manufactured from any metal, although aluminum, nickel and copper and alloys thereof are most often used. A metal mesh is in the form of a flat sheet and it is not easily conformed to a three-dimensional shape unless it is cut, manipulated and overlapped. Overlapping and folding of the metal wire mesh can be problematic since the overlapped region can block resin flow during injection which can result in a greater fiber/resin ratio than the rest of the article. Areas with a greater fiber/resin ratio can cause surface dryness that results in cracking and aesthetically inferior products.

To minimize problems of wire overlap that may affect the injection of the resin the wire mesh is cut at precise areas to conform to the fiber preform. After the mesh has been cut and conformed into the required shape a means to maintain the contours and configuration must be provided. In addition, if the article being manufactured requires the incorporation of more than one wire mesh for additional electrical protection, then a means to secure a second wire mesh to the first wire mesh is needed.

An adhesive resin is used to adhere metal meshes and fabric preforms. The adhesive resin film consists of a resin that may contain a cross-linking agent. A cross-linking agent is added to the adhesive resin film to give it some rigidity if the resin is too viscous to be manufactured in film form. However, if the adhesive resin does not contain a cross-linking agent it must be soluble in the injection resin system under the injection molding conditions.

The adhesive resin film may be manufactured from a resin system identical to, or chemically and physically compatible to the injection resin. The objective is to assemble an article that allows for the dissolution of the adhesive resin into the injected resin without forming undesirable by-products during curing.

Thermosetting injection resins are typically used in this method. Bisphenol-A epoxy (BisA epoxy), Bismaleimide modified epoxy (BMI epoxy), and triazine, as manufactured by U.S. Polymeric in santa Anna, CA, are preferred. These resin systems may be a one component or multi-component composition comprised of the above mentioned systeme and may contain a cross-linking agent.

If a cross-linking agent is needed it is mixed with the resin prior to injection into the resin transfer molding tool. The cross-linking agent may consist of one or a combination of compounds chosen from the following classes: organic acids, anhydridee, amines and organometallics.

It will be understoood by those skilled in the art that the invention is carried out with resin transfer molding tools having patterned matching mold halves. In addition, the method to manufacture an article with at least one metal mesh may be achieved in several ways.

The amount of adhesive resin film needed to secure the metal wire mesh to the preform is approximately proportional to the complexity and curvature of the structure. A flat structure might need approximately 2% of the preform surface covered with the resin film adhesive, whereas a complex structure might need approximately 25% or more of the preform surface covered to secure the metal wire mesh.

In a first method, the metallic wire mesh is laid on the resin transfer molding tool matched first half. The exposed tacky resin is adhered to the wire mesh. A stabilized fiber preform is placed on the wire mesh and adhesive resin.

A second method to carry out the invention is to first place a stabilized fiber preform on the tool. Adhesive resin shapes are adhered to the preform, and a patterned metal wire mesh is placed on the exposed tacky resin and preform.

Some conductive composite articles may require more than one metallic mesh. In this case, adhesive resin shapes are used to secure the first wire mesh to the preform, and to secure the two interfacing meshes. Thus, a preform is laid on a tool, adhesive resin shapen are adhered to the preform. A plurality of adhesive shapes are adhered to the preform and a first metal mesh is placed on the exposed tacky resin and preform. A plurality of second adhesive resin film shapes are attached to the first metal mesh. The second wire mesh is interfaced to the first mesh with the exposed resin.

Another method to assemble an article comprises placing a metal mesh or screen on each side of a fabric and securing the meshes with tacky adhesive resin strips. This layering method is also useful if an article requires a fabric to be adhered on each side of a metal mesh.

Once the article has been assembled with any of the methods described above, the molding tool is closed and the matrix resin is injected either into an approximately room temperature or a preheated tool. After injection the assembled tool is cured with heat for approximately 1/2 hrs. and up to approximately 8.0 hrs., at a temperature between about 250°F to 400°F.

The foregoing and other features and advantages of the present invention will become more apparent from the following description and accompanying drawings.

### Brief Description of Drawings

Fig. 1 shows the elements used to manufacture a conductive composite article with a resin transfer molding process according to this invention.

Fig. 2 shows an overlapped metal wire mesh secured with an adhesive resin film strip according to this invention.

### Best Mode for Carrying Out the Invention

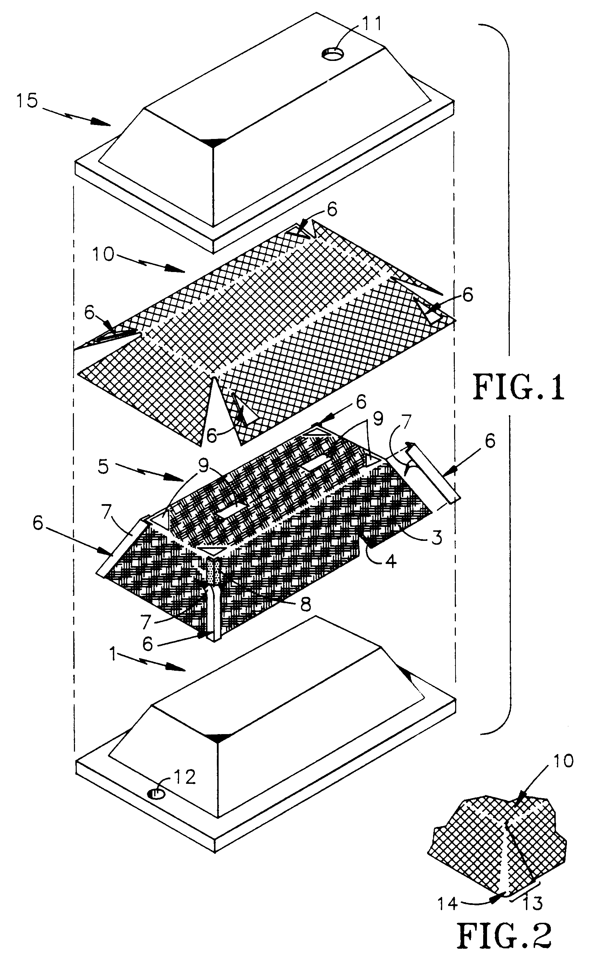

The preferred mode to carry out the invention is best described by referring to Figures 1 and 2, which illustrate the method to fabricate a composite article by placing the fiber preform on the resin transfer molding tool and adhering the wire mesh. Looking at Fig. 1 a preform fabric (3) is cut to the required pattern. The preform is manufactured with graphite fibers (4) and a fiberglass outer ply. The patterned fabric (3) has been formed into a preform structure (5) by conventional techniques. The dry preform (5) is laid on a molding tool matched first half (1). Adhesive resin film E-905HM, as provided by U.S. Polymeric, Santa Anna, CA., composed of epoxy modified bismaleimide resin, is defrosted and a sheet of film is cut into shapes (6) with conventional cutting techniques. The resin film has a first and second support layers on each side. One of the removable support layers (7) is peeled from the adhesive resin strips (6) and the exposed tacky resin (8) is adhered to the fiber preform (3) with light hand pressure. The adhesive resin strips are adhered to the areas designated as (9), where the metallic mesh (10) needs to be secured to the fiber preform (3). The areas covered with triangular shaped adhesive resin (6) strips, illustrated the regions that require the wire mesh to be adhered to the fiber preform and to bond areas where portions of the metal mesh overlap with each other. Approximately 10% of the preform is covered with the adhesive resin shaped. To ensure the flow of the injected resin, during a subsequent impregnation step described in more detail below, the adhesive resin strips are not adhered to the fiber preform areas which lie adjacent the injection port (11) and the bleed ports (12) since the flow rate of the resin would be affected and the excess resin would not flow properly.

The second support layer (7) is removed from the adhesive resin film strips. A 200x200 mesh aluminum metal sheet (10) which has been cleaned with conventional degreasers, is cut to match the preform pattern, and placed on the fiber preform (5). The wire mesh is adhered to the exposed tacky resin with light hand pressure. Fig. 2 illustrates the area of wire overlap (13). The white regions (14) show the adhesive resin film holding the wire mesh in place and securing the overlap. In the areas of the wire overlap, adhesive resin strips are used to physically secure the wire to maintain the required configuration.

Once the wire mesh has been secured to the fiber preform, the matching mold tool second half (15) is assembled to the first half (1) and the assembly is closed. The matching molding tool is heated to 230°F. The injection resin E905RTMA, as supplied by U.S. Polymerics in Santa Anna, CA., is an epoxy modified bismaleimide matrix resin, the resin is mixed with a cross-linking agent, such as E905RTMB following the specifications of the supplier, and is injected into the tool through the injection port (11). The closed molding tool is than cured in a 350°F preheated oven for 2 hrs. to allow the resins to thermoset.

After the cure cycle the thermoset conductive composite article is removed from the tool and is subjected to quality control inspection and non-destructive tests known in this field of art.

Although this invention has been shown and described with respect to detailed embodiments thereof, it will be understood by those skilled in the art that various changes in form and detail thereof may be made without departing from the scope of the claimed invention.

## Claims

1. A method to manufacture conductive composite articles with a resin transfer molding process using an adhesive resin film having compatible chemical and physical properties with an injection resin and a first and a second tacky surface, comprising:
a. placing a fiber preform on a resin transfer molding tool matching first half;
b. adhering shapes of said adhesive resin film to the fiber preform;
c. placing a patterned metal wire mesh on the fiber preform;
d. adhering the metal mesh to the exposed adhesive resin tacky surface;
e. assembling a resin transfer molding tool matching second half to said transfer molding tool matching first half;
f. injecting a matrix resin and a cross-linking agent into said assembled resin transfer molding tool;
g. heating said assembled resin transfer molding tool to cure said resin and adhesive resin.

2. A method according to claim 1 further comprising between steps d and e:
adhering shapes of said adhesive tacky resin to the first metal mesh;
interfacing a second metal mesh to the first metal mesh.

3. A conductive composite article manufactured according to the method of claim 1.

4. A method to manufacture conductive composite articles with a resin transfer molding process using an adhesive resin film having compatible chemical and physical properties with an injection resin, and a first and a second adhesive tacky surface comprising:
a. placing a patterned metal mesh on a resin transfer molding tool first matched half;
b. adhering shapes of said adhesive tacky resin to the metal mesh;
c. placing a fiber preform on the metal mesh;
d. adhering the fiber preform to the adhesive resin tacky surface;
e. assembling said resin molding tool first matching half to said resin transfer molding tool second matching half;
f. injecting a matrix resin and a cross-linking agent into said assembled resin transfer molding tool;
g. heating said assembled resin transfer molding tool to cure said resin and adhesive resin.

5. A method according to claim 4 further comprising between steps b and c:
adhering shapes of said adhesive tacky resin to the first metal mesh;
interfacing a second metal mesh to the first metal mesh.

6. A conductive compseite article manufactured according to the method of claim 4.

## Patentansprüche

1. Verfahren zum Herstellen von leitfähigen Verbundgegenständen mit einem Harzspritzpreßprozeß unter Verwendung einer Klebharzfolie, die kompatible chemische und physikalische Eigenschaften mit einem Spritzharz sowie eine erste und eine zweite klebrige Oberfläche hat, beinhaltend:
a. Plazieren eines Faservorformlings auf der ersten Hälfte eines zweiteiligen Harzspritzpreßwerkzeuges;
b. Ankleben von Formteilen der Klebharzfolie an den Faservorformling;
c. Plazieren eines nach Muster zugeschnittenen Metalldrahtnetzes auf dem Faservorformling;
d. Ankleben des Metallnetzes an die freiliegende, klebrige Klebharzoberfläche;
e. Zusammenbauen einer zweiten Hälfte des Harzspritzpreßwerkzeuges mit der ersten Hälfte des Harzspritzpreßwerkzeuges;
f. Einspritzen eines Matrixharzes und eines Vernetzungsmittels in das zusammengebaute Harzspritzpreßwerkzeug;
g. Erhitzen des zusammengebauten Harzspritzpreßwerkzeuges, um das Harz und das Klebharz zu härten.

2. Verfahren nach Anspruch 1, weiter beinhaltend zwischen den Schritten d und e:
Ankleben von Formteilen des klebrigen Klebharzes an das erste Metallnetz;
Verbinden eines zweiten Metallnetzes mit dem ersten Metallnetz.

3. Leitfähiger Verbundgegenstand, hergestellt durch das Verfahren nach Anspruch 1.

4. Verfahren zum Herstellen von leitfähigen Verbundgegenständen durch einen Harzspritzpreßprozeß unter Verwendung einer Klebharzfolie, die kompatible chemische und physikalische Eigenschaften mit einem Spritzharz sowie eine erste und eine zweite klebrige Klebstoffoberfläche hat, beinhaltend:
a. Plazieren eines nach Muster zugeschnittenen Metallnetzes auf der ersten Hälfte eines zweiteiligen Harzspritzpreßwerkzeuges;
b. Ankleben von Formteilen des klebrigen Klebharzes an das Metallnetz;
c. Plazieren eines Faservorformlings auf dem Metallnetz;
d. Ankleben des Faservorformlings an die klebrige Klebharzoberfläche;
e. Zusammenbauen der ersten Hälfte des Harzspritzpreßwerkzeuges mit der zweiten Hälfte des Harzspritzpreßwerkzeuges;
f. Einspritzen eines Matrixharzes und eines Vernetzungsmittels in das zusammengebaute Harzspritzpreßwerkzeug;
g. Erhitzen des zusammengebauten Harzspritzpreßwerkzeuges zum Härten des Harzes und des Klebharzes.

5. Verfahren nach Anspruch 4, weiter beinhaltend zwischen den Schritten b und c:
Ankleben von Formteilen des klebrigen Klebharzes an das erste Metallnetz;
Verbinden eines zweiten Metallnetzes mit dem ersten Metallnetz.

6. Leitfähiger Verbundgegenstand, hergestellt durch das Verfahren nach Anspruch 4.

## Revendications

1. Une méthode pour fabriquer des articles conducteurs composites avec un procédé de moulage par transfert de résine utilisant un film de résine adhésive ayant des propriétés chimiques et physiques compatibles avec une résine à injecter et une première et une seconde surfaces collantes, comprenant:
a. le placement d'une préforme de libres sur une première moitié appariée d'un outil de moulage par transfert de résine;
b. l'adhérence de formes dudit film de résine adhésive à la préforme de fibres;
c. le placement d'un treillis d'armature métallique modelé sur la préforme de fibres;
d. l'adhérence du treillis métallique à la surface collante de résine adhésive exposée;
e. l'assemblage d'une seconde moitié appariée de l'outil de moulage par transfert de résine sur ladite première moitié appariée de l'outil de moulage par transfert;
f. l'injection d'une matrice de résine et d'un agent de réticulation dans ledit outil de moulage par transfert de résine assemblé;
g. le chauffage dudit outil de moulage par transfert de résine assemblé pour durcir lesdites résine et résine adhésive.

2. Une méthode conformément à la revendication 1, comprenant en outre, entre les étapes d et e:
l'adhérence de formes de ladite résine adhésive collante au premier treillis métallique;
la liaison d'un second treillis métallique au premier treillis métallique.

3. Un article conducteur composite fabriqué conformément à la méthode de la revendication 1.

4. Une méthode pour fabriquer des articles conducteurs composites avec un procédé de moulage par transfert de résine utilisant un film de résine adhésive ayant des propriétés chimiques et physiques compatibles avec une résine à injecter et une première et une seconde surfaces adhésives collantes, comprenant:
a. le placement d'un treillis métallique modelé sur une première moitié appariée d'un outil de moulage par transfert de résine;
b. l'adhérence de formes de ladite résine adhésive collante au treillis métallique;
c. le placement d'une préforme de fibres sur le treillis métallique;
d. l'adhérence de la préforme de fibres à la surface de résine adhésive collante;
e. l'assemblage de ladite première moitié appariée de l'outil de moulage de résine sur ladite seconde moitié appariée de l'outil de moulage par transfert de résine;
f. l'injection d'une matrice de résine et d'un agent de réticulation dans ledit outil de moulage par transfert de résine assemblé;
g. le chauffage dudit outil de moulage par transfert de résine assemblé pour durcir lesdites résine et résine adhésive.

5. Une méthode conformément à la revendication 4 comprenant en outre, entre les étapes b et c:
l'adhérence de formes de ladite résine adhésive collante au premier treillis métallique;
la liaison d'un second treillis métallique au premier treillis métallique.

6. Un article conducteur composite fabriqué conformément à la méthode de la revendication 4.
